# EUROPÄISCHE PATENTSCHRIFT

(11) **EP 1 313 891 B1**
(45) Veröffentlichungstag und Bekanntmachung des Hinweises auf die Patenterteilung: **04.03.2009**
(21) Anmeldenummer: 01971962.4
(22) Anmeldetag: 24.08.2001
(51) Int. Cl.: C23C 16/458, C30B 25/12

(54) **CVD-BESCHICHTUNGSVORRICHTUNG**
CVD COATING DEVICE
DISPOSITIF DE DEPOT CHIMIQUE EN PHASE VAPEUR

(30) Priorität: 01.09.2000 DE 10043600
(43) Veröffentlichungstag der Anmeldung: 28.05.2003
(73) Patentinhaber: Aixtron AG, 52072 Aachen (DE)
(72) Erfinder: JÜRGENSEN, Holger, 52072 Aachen (DE); KÄPPELER, Johannes, 52146 Würselen (DE); STRAUCH, Gerd, 52072 Aachen (DE)
(74) Vertreter: Grundmann, Dirk
(86) Internationale Anmeldenummer: PCT/EP2001/009795
(87) Internationale Veröffentlichungsnummer: WO 2002/018672

(56) Entgegenhaltungen:
- JP-A- 02 212 394
- US-A- 5 027 746
- US-A- 5 782 979
- US-A- 5 788 777
- US-A- 5 820 686

## Beschreibung

Die Erfindung betrifft eine Vorrichtung, wie sie aus der US 5,782,979 bekannt ist. Dort liegen auf einer Trägerplatte mehrere Substrathalter. In den Zwischenräumen zwischen den Substrathaltern liegen Kompensationsplatten.

Eine ähnliche Vorrichtung ist aus der JP 2212394 bekannt. Dort liegen die Substrathalter in Aussparungen einer Platte, die auf einer Trägerplatte aufliegt.

Aus dem US-Patent 5,788,777, dem US-Patent 5,027,746 und dem DE-Patent 19813523 C2 sind ähnliche Vorrichtungen bekannt. In der von der Rückseite insbesondere mit Hochfrequenz beheizbaren Trägerplatte aus Grafit liegen Substrathalter lose in ihnen zugeordneten Aussparungen ein. Bei diesem Stand der Technik werden die Substrathalter auf einem Gaspolster liegend zufolge einer besonderen Gaskanalführung im Boden der Trägerplattenaussparung drehangetrieben. Das lose Aufliegen des Substrathalters auf dem Boden der Aussparung der Trägerplatte, in welcher der Substrathalter so einliegt, dass er mit seiner Oberfläche bündig zu seiner Umgebung liegt, hat die Ausbildung einer Horizontalfuge zur Folge, die sich sogar noch verbreitert, wenn der Substrathalter in der beschriebenen Weis drehangetrieben wird. Die Horizontalfuge bildet eine Störung des Wärmetransportes von der rückwärtig der Trägerplatte liegenden Heizung der Prozesskammer. Dies hat zur Folge, dss die Oberflächentemperatur des Substrathalters niedriger ist als die Oberflächentemperatur des Umgebung. Dies hat auch Auswirkungen auf den Isothermenverlauf im Gasstrom über der Trägerplatte.

Die WO96/23913 schlägt eine SiC-Schutzplatte für einen Substrathalter vor.

Der Erfindung liegt die Aufgabe zugrunde, Maßnahmen anzugeben, um die Qualität der abgeschiedenen Schichten zu verbessern.

Gelöst wird die Aufgabe durch die in den Ansprüchen angegebenen Lösungen.

Der Anspruch 1 schlägt zunächst und im Wesentlichen eine, auf der Trägerplatte liegende, an den Substrathalter angrenzende Kompensationsplatte vor. Der Rand der Kompensationsplatte folgt dabei der Kontur des Substrathalters. Der Substrathalter ist von ein oder mehreren Kompensationsplatten umschlossen. Es sind bevorzugt eine Vielzahl von Substrathaltern vorgesehen, die planetenartig auf der insbesondere auch drehangetriebenen Trägerplatte angeordnet sind. Die Kompensationsplatten liegen dann segmentartig auf der ringförmigen Trägerplatte. Die Kompensationsplatten können aus TaC oder aus mit TaC- oder SiC-beschichtetem Grafit bestehen. Sie können als Verbrauchsteile ausgetauscht werden. Zur randseitigen Lagerung der kreisscheibenförmigen Substrathalter sind Zentrierringe vorgesehen. Diese Zentrierringe liegen ebenfalls in den Aussparungen der Trägerplatte. An diese Zentrierringe stoßen die runden. Randkanten der Kompensationsplatten. Auf den Zentrierringen liegen Abdeckringe, die auch einen gestuften Randabschnitt des Substrathalters überdecken. Die Trägerplatte wird von unten mittels einer zentralen Stützplatte getragen. Dies erfolgt durch Randuntergriff. Oberhalb der Stützplatte kann eine Zugplatte liegen, die sich ebenfalls auf dem Rand der Trägerplatte abstützt. In der Mitte der Zugplatte kann eine Zugstange angreifen, so dass der Rand der Trägerplatte gleichsam eingespannt ist. Die äußere Begrenzung der Prozesskammer wird von einem Gasauslassring ausgebildet, der eine Vielzahl von radialen Gasaustrittsöffnungen besitzt. Dieser soll ebenso wie eine zur Trägerplatte sich parallel und beabstandet erstreckende, ebenfalls rückwärtig beheizte Deckenplatte aus massivem Grafit bestehen. Zufolge dieser Ausgestaltung hat der Gasauslassring eine erhöhte Wärmekapazität und gleichzeitig eine gute Wärmeleitung, so dass von Deckplatte zu Trägerplatte ein stetiger Temperaturverlauf vorliegt.

Eine bevorzugte Form der Erfindung betrifft ferner eine Weiterbildung der aus der US 57 88 777 grundsätzlich schon bekannten Deckplatte und deren Halterung am Gaseinlassorgan. Bei der Epitaxie von SiC mit den Reaktionsgasen Silan und Methan/Propan sind die aus Grafit bestehende Trägerplatte und eine ebenfalls aus Grafit bestehende Deckplatte innert beschichtet. Die Beschichtung kann aus TaC oder SiC bestehen. Derartig beschichtete Deck- oder Trägerplatten unterliegen einem Verschleiß, da die Reaktionsgase eine ätzende Wirkung entfalten. Erfindungsgemäß wird die Deckplatte mit austauschbaren Verkleidungsringen verkleidet, welche aus TaC bestehen können. Die Verkleidungsringe halten sich durch gegenseitigen Untergriff. Der innenliegende Ring kann mit seinem Rand auf der Tragschulter eines Trägers liegen, der an einem Gaseinlassorgan sitzt. In einer Variante der Erfindung ist vorgesehen, dass die Verkleidungsringe aus Grafit bestehen und mit TaC oder SiC beschichtet sind. Die Verkleidungsringe liegen in gegenseitiger Randauflage auf jeweils dem innenliegenderen Ring auf. Der innere der konzentrisch zueinander angeordneten Verkleidungsringe können dabei mehrteilig ausgebildet sein. Insbesondere ist an eine segmentartige Mehrteiligkeit gedacht.

Ein Ausführungsbeispiel der Erfindung wird nachfolgend anhand beigefügter Zeichnungen erläutert. Es zeigen:

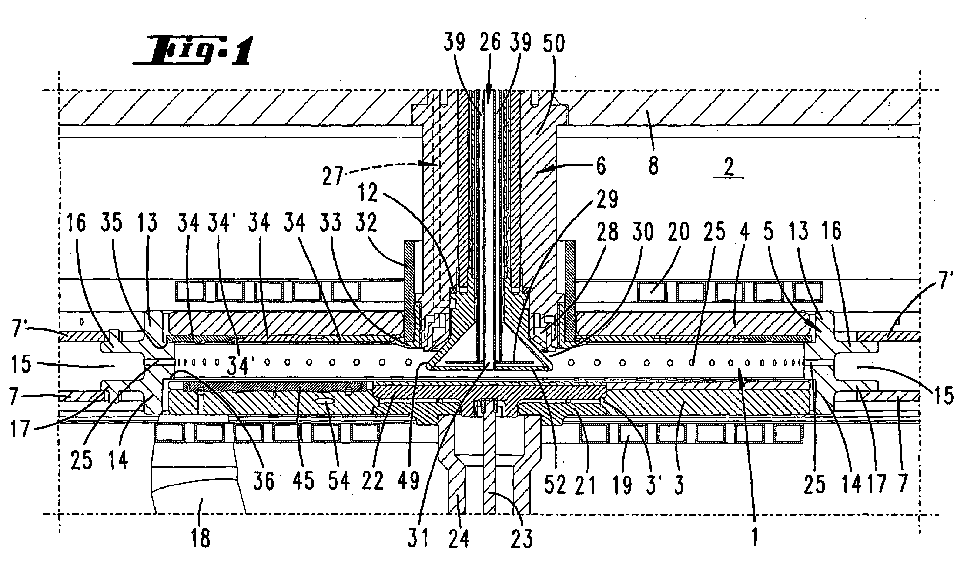

- Fig. 1: in schematischer Darstellung eine Prozesskam- mer eines Reaktors,

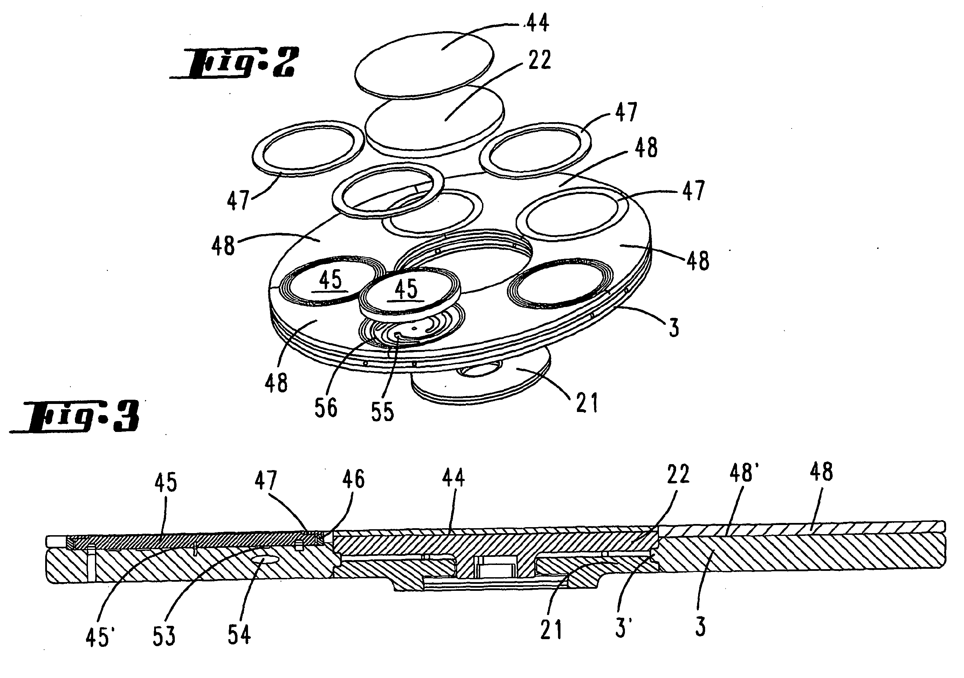

- Fig. 2: eine Explosionsdarstellung der Trägerplatte nebst Substrathalters,
- Fig. 3: einen vergrößerten Schnitt durch die Träger- platte gemäß der Schnittansicht Figur 1 und

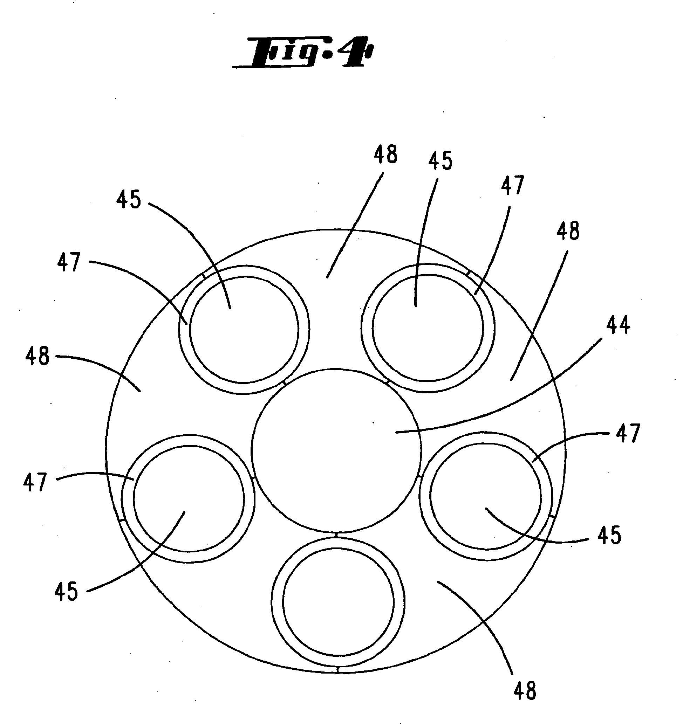

- Fig. 4: eine Draufsicht auf die Trägerplatte.

Die im Ausführungsbeispiel dargestellte Vorrichtung dient zum monokristallinen Abscheiden von SiC-Schichten auf monokristallinen Si-Substraten, diese Substrate können einen Durchmesser von 4 Zoll besitzen.

In einem Reaktorgehäuse 2 befindet sich eine Prozesskammer 1. Diese Prozesskammer 1 besitzt eine Trägerplatte 3, die die Substrathalter 45 trägt. Parallel zur Trägerplatte 3 erstreckt sich oberhalb dieser eine Deckplatte 4. Die Trägerplatte 3 wird von unten mittels einer wassergekühlten HF-Spule 19 beheizt. Die Deckplatte 4 wird von oben mit einer ebenfalls wassergekühlten HF-Spule 20 beheizt. Die Trägerplatte 3 ist ringförmig gestaltet, wobei der Außendurchmesser etwa doppelt so groß ist wie der Innendurchmesser. Die Innenwandung der Trägerplatte 3 besitzt eine radial einwärts ragende Ringstufe 3'.Mit dieser Ringstufe 3' liegt die Trägerplatte 3 auf dem Rand einer Stützplatte 1 auf. Die Stützplatte 1 stützt sich wiederum auf einem Stützrohr 24 ab, welches von einer Zugstange 23 durchragt wird. Die Zugstange 23 greift etwa mittig an einer oberhalb der Stützplatte 21 angeordneten Zugplatte 22 an, welche mit ihrem Rand auf den Kragen 3' aufliegt. Durch Zug an der Zugstange 23 von unten wird die Trägerplatte 3 klemmbackenartig gehalten.

Die Trägerplatte 3 und die Deckplatte 4 werden von einem Gasauslassring 5 umgeben. Dieser Gasauslassring 5 bildet die seitliche Prozesskammer-Wand. Der Gasauslassring 5 besitzt eine Vielzahl von radialen Bohrungen 25, durch welche das Prozessgas austreten kann. Der Gasauslassring 5 ist ebenso wie die Stützplatte 21, die Zugplatte 22, die Trägerplatte 3 und die Deckplatte 4 aus massivem Grafit gefertigt. Er ist einstückig und hat eine Breite, die etwa der Höhe der Prozesskammer 1 entspricht. Hierdurch besitzt der Gasauslassring 5 eine relativ hohe Wärmekapazität, was zur Folge hat, dass das Temperaturprofil innerhalb der Prozesskammer auch am Rand sehr homogen ist. Indem der Gasauslassring 5 eine von der Deckplatte 4 überfangene Stufe 35 und eine von der Trägerplatte unterfangene Stufe 36 ausbildet, ragt er bereichsweise in den Zwischenraum von Deckplatte 4 und Trägerplatte 3.

Die Deckplatte 4 ist an ihrer Unterseite mit insgesamt drei Verkleidungsringen 34 ausgefüttert. Diese Verkleidungsringe können aus Grafit bestehen oder aus TaC. Sie werden ähnlich wie Ofenringe durch gegenseitigen übergriff aneinander gehalten, wobei sich der innerste Ring 34 auf einen Ringkragen eines Grafitträgers 33 abstützt, welcher auf das untere Ende des Gaseinlassorganes 6 aufgeschraubt ist. Im Bereich des übereinanderliegens sind die Verkleidungsringe 34 gefälzt. Sie bilden übereinanderliegende Ringabschnitte 34', 34" aus, so dass ihre Oberfläche stufenlos verläuft.

Das Gaseinlassorgan 6 ist insgesamt zweiteilig ausgebildet. Es besitzt einen Kern, der einen in die Prozesskammer 1 ragenden Abschnitt 49 ausbildet, welche eine Kegelstumpfgestalt besitzt. Dieser Kern wird von einem Mantel 50 umgeben. Mittels O-Ringdichtung 12 ist der Mantel 50 gegenüber dem Kern 49 abgedichtet.

Die Zuführung des Silans erfolgt durch die Zuleitung 27. Es tritt durch eine ringkeilförmige Öffnung 30 aus. Die Wände des Kanals 30 sind gekühlt. Hinter den Kanalwänden befinden sich Kühlwasserkammern 28; durch welche Kühlwasser strömt um die Wandungstemperatur unterhalb der Zerlegungstemperatur des Silans zu halten.

Die Basisfläche 52 welche ebenfalls zufolge rückwärtiger Kühlwasserbeaufschlagung bei einer Temperatur gehalten ist, bei welcher sich die Reaktionsgase nicht zerlegen, befindet sich etwa in der Mitte der Prozesskammer und verläuft parallel zur Oberfläche der Trägerplatte 3 In der Mitte der Basisfläche 52 befindet sich die Öffnung 31 der Methan- bzw. Propan-Zuleitung 26. Die Prozessgase werden ebenfalls zusammen mit Wasserstoff durch die ihnen zugeordneten Zuleitungen 26,27 geleitet.

Um die beim Betrieb der Vorrichtung etwa bis auf 1600°C aufgeheizte Deckplatte 4 von dem gekühlten Gaseinlassorgan 6 zu isolieren, ist eine Isolationsmanschette 32 aus einem Kohlenstoffschaum vorgesehen, welche auf dem Träger 33 sitzt.

Die Trägerplatte 3 wird über das Stützrohr 24 drehangetrieben. Die Trägerplatte 3 besitzt zudem Kanäle 54, durch welche Gas strömt, welches in Spiralnuten 55 austritt, die sich am Boden von Aussparungen 56 befinden. In den Aussparungen 56 liegen die Substrathalter 45 ein. Sie drehen sich auf einem Gaspolster des Gases, das durch die Spiralnuten 55 strömt. Die Substrathalter 45 sind von Zentrierringen 46 umgeben, die auch in der Aussparung 56 einliegen und am Rand der Aussparung anliegen. Der Randbereich der Oberfläche der Substrathalter 45 besitzt eine Stufe. Auf dieser Stufe liegt ein auch den Zentrierring 56 überdeckender Abdeckring 47. Die Bereiche zwischen den Substrathaltern 45 bzw. den Zentrierringen 46 bzw. Abdeckringen 57 werden von Kompensationsplatten 48 ausgefüllt. Diese liegen lose auf der Oberfläche der Trägerplatte 3 auf. Die Oberflächen von Substrathalter 45, Abdeckring 47 und Kompensationsplatte 48 fluchten zueinander. Die Kompensationsplatten 48 sind vorzugsweise aus TaC gefertigt und austauschbar.

Wird die Trägerplatte 3 von unten beheizt, so tritt im Bereich der Horizontalfuge 48' zwischen Kompensationsplatte 48 und Trägerplatte 3 etwa der gleiche Temperatursprung auf, wie an der Horizontalfuge 45' zwischen Substrathalter 45 und Trägerplatte 3

Am Ausführungsbeispiel sind insgesamt 5 Substrathalter 45 vorgesehen, die planetenartig um das Zentrum der Trägerplatte 3 angeordnet sind. Sie haben eine kreisförmige Aussenkontur. Die Kompensationsplatten 48 liegen zwischen den Substrathaltern 45 und ergänzen sich zu einer ringförmigen Gestalt. Die innere Öffnung der ringförmigen Plattenanordnung, in welcher die Zugplatte 22 sitzt, wird von einer kreisrunden Kompensationsplatte 44 ausgefüllt, die lose auf der Zugplatte 22 aufliegt.

Alle offenbarten Merkmale sind (für sich) erfindungswesentlich.

## Patentansprüche

1. Vorrichtung zum Abscheiden insbesondere kristalliner Schichten auf einem oder mehreren, insbesondere ebenfalls kristallinen Substraten in ei ner Prozesskammer (1) mittels in die Prozesskammer (1) eingeleiteten und sich dort pyrolytisch umsetzenden Reaktionsgasen, mit einer beheizbaren Trägeplatte (3), auf welcher mindestens ein Substrathalter (45) lose und oberflächenbündig zu mindestens einer auf der Trägerplatte liegenden, an den mindestens einen Substrathalter konturfolgend angrenzende Kompensationsptatte (48) liegt, **gekennzeichnet durch** einen den drehbaren Substrathalter (45) umfassenden Zentrierring (46), welcher zusammen mit dem Substrathalter (45) in einer Trägerplattenaussparung (56) liegt, und einen den Zentrierring (46) und einen abgestuften Rand des Substrathalters (45) überfangenden. Abdeckring (47).

2. Vorrichtung nach Anspruch 1, **dadurch gekennzeichnet, dass** die Kompensationsplatte (48) aus TaC oder TaC- oder SiC-beschichtetem Grafit besteht.

3. Vorrichtung nach einem der vorhergehenden Ansprüche, **dadurch gekennzeichnet, dass** die Trägerplatte (3) eine Ringform aufweist und von unten von einer zentralen Stützplatte (21) durch Randuntergriff getragen wird.

4. Vorrichtung nach Anspruch 3, gekenntzeichnet durch eine über der Stützplatte (21) liegende Zugplatte (22), die sich auf dem Rand (3') der Trägerplatte (3) abstützt und an der eine Zugstange (23) abgreift.

5. Vorrichtung nach einem der vorhergehenden Ansprüche **dadurch gekennzeichnet, dass** der Außendurchmesser der ringförmigen Trägerplatte (3) doppelt so groß ist wie ihr Innendurchmesser.

6. Vorrichtung nach einem der vorhergehenden Ansprüche, **dadurch gekennzeichnet, dass** die Trägerplatte (3) drehangetrieben ist.

7. Vorrichtung nach einem der vorhergehenden Ansprüche, **dadurch gekennzeichnet, dass** der drehbare Substrathalter (45) auf einem Gaspolster aufliegend durch das Gaspolster bildende Gasströme drehangetrieben ist.

8. Vorrichtung nach einem der vorhergehenden Ansprüche, **gekennzeichnet durch** eine Vielzahl um das Zentrum der Trägerplatte (3) angeordnete, jeweils mittels Gasströmen drehangetriebene Substrathalter (45).

9. Vorrichtung nach einem der vorhergehenden Ansprüche, **dadurch gekennzeichnet, dass** dem Substrathalter (45) eine Deckplatte (4) mit Abstand gegenüberliegt und dass die Deckplatte (4) auf ihrer auf den Substrathalter (45) weisenden Seite mit innertbeschichteten oder aus innertem Material bestehenden Platten (34) verkleidet ist.

10. Vorrichtung nach Anspruch 9, **dadurch gekennzeichnet, dass** die Hatten (34) als konzentrisch zueinander angeordnete Verkleidungsringe ausgebildet sind.

11. Vorrichtung nach einem der Ansprüche 9 oder 10, **dadurch gekennzeichnet, dass** die Verkleidungsringe (34) aus TaC oder aus TaC -oder SiC-beschichtetem Grafit bestehen.

12. Vorrichtung nach einem der Ansprüche 9 bis 11, **dadurch gekennzeichnet dass** der innerste Verkleidungsring (34) von einem Gaseinlassorgan (6) getragen wird und sich die jeweils äußeren Ringe (34) mit ihrem jeweiligen Innenrand (34') auf dem jeweils äußeren Rand (34') des jeweils benachbarten inneren Ringes (34) abstützen.

13. Vorrichtung nach einem der Ansprüche 9 bis 12, **dadurch gekennzeichnet, dass** der innere der konzentrisch zueinander angeordneten Verkleidungsringe (34) mehrteilig ausgeführt ist.

## Claims

1. A device for depositing in particular crystalline layers on one or more, in particular likewise crystalline substrates in a process chamber (1) by means of reaction gases which are introduced into the process chamber (1), where they react pyrolytically, having a heatable carrier plate (3), in which at least one substrate holder (45) rests loosely, with its surface flush with at least one compensation plate (48) which is located on the carrier plate and borders on the at least one substrate holder such that it follows the shape of the substrate holder, **characterized by** a centering ring (46) which surrounds the rotatable substrate holder (45) and, together with the substrate holder (45), is located in a cutout (56) in the carrier plate, and a covering ring (47) which engages over the centering ring (48) and a stepped edge of the substrate holder (45).

2. A device according to claim 1, **characterized in that** the compensation plate (48) consists of TaC, or TaC-coated or SiC-coated graphite.

3. A device according to either of the preceding claims, **characterized in that** the carrier plate (3) is annular in shape and is supported from below by a central support plate (21) engaging beneath the edge of the carrier plate.

4. A device according to Claim 3, **characterized by** a tension plate (22), which is located above the support plate (21), is supported on the edge (3') of the carrier plate (3) and on which a tie rod (23) acts.

5. A device according to any of the preceding claims, **characterized in that** the outer diameter of the carrier plate (3) is double its inner diameter.

6. A device according to any of the preceding claims, **characterized in that** the carrier plate (3) is driven in rotation.

7. A device according to any of the preceding claims, **characterized in that** the rotatable substrate holder (45), resting on a gas cushion, is driven in rotation by gas streams which form the gas cushion.

8. A device according to any of the preceding claims, **characterized by** a plurality of substrate holders (45) which are disposed around the center of the carrier plate (3) and are each driven in rotation by means of gas streams.

9. A device according to any of the preceding claims, **characterized in that** a cover plate (4) is located opposite and at a spacing from the substrate holder (45) and **in that** the cover plate (4), on its side which faces towards the substrate holder (45), is clad with inert-coated plates (34) or of plates (34) which consist of inert material.

10. A device according to Claim 9, **characterized in that** the plates (34) are formed as cladding rings disposed concentrically with respect to one another.

11. A device according to either of Claims 9 or 10, **characterized in that** the cladding rings (34) consist of TaC, or of TaC-coated or SiC-coated graphite.

12. A device according to any of Claims 9 to 11, **characterized in that** the innermost cladding ring (34) is supported by a gas admission element (6), and in each case the outer rings (34) are supported, in each case by means of their inner edge (34'), on in each case the outer edge (34') of in each case the adjacent inner ring (34).

13. A device according to any of Claims 9 to 12, **characterized in that** the inner one of the cladding rings (34) that are disposed concentrically with respect to one another is of multipart construction.

## Revendications

1. Dispositif de dépôt de couches, notamment cristallines, sur un ou plusieurs substrats, notamment également cristallins, dans une chambre de réaction (1) au moyen de gaz de réaction qui sont injectés dans la chambre de réaction (1) dans laquelle ils sont convertis par pyrolyse, ledit dispositif comportant une plaque de support chauffante (3) sur laquelle est placée, de façon amovible, au moins un porte-substrat (45) dont la surface est à fleur de la surface d'au moins une plaque de compensation (48) qui se trouve sur la plaque de support et qui est adjacente, en suivant le contour, à l'au moins un porte-substrat, **caractérisé par** une bague de centrage (46) qui entoure le porte-substrat rotatif (45) et qui se trouve, avec le porte-substrat rotatif (45), dans une cavité (56) de la plaque de support, et par une bague de recouvrement (47) s'engageant par-dessus la bague de centrage (46) et un bord en gradin du porte-substrat (45).

2. Dispositif selon la revendication 1, **caractérisé en ce que** la plaque de compensation (48) est en TaC ou en graphite recouvert de TaC ou de SiC.

3. Dispositif selon l'une des revendications précédentes, **caractérisé en ce que** la plaque de support (3) a une forme annulaire et est supportée par au-dessous par une plaque de soutien centrale (21) en s'engageant depuis le bas au niveau des bords.

4. Dispositif selon la revendication 3, **caractérisé par** une plaque de traction (22) qui se trouve au-dessus de la plaque de soutien (21), qui s'appuie sur le rebord (3') de la plaque de support (3) et avec laquelle s'engage une barre de traction (23).

5. Dispositif selon l'une des revendications précédentes, **caractérisé en ce que** le diamètre extérieur de la plaque de support annulaire (3) est égal à deux fois son diamètre intérieur.

6. Dispositif selon l'une des revendications précédentes, **caractérisé en ce que** la plaque de support (3) est entraînée en rotation.

7. Dispositif selon l'une des revendications précédentes, **caractérisé en ce que** le porte-substrat rotatif (45) est entraîné en rotation par des flux de gaz formant un coussin de gaz sur lequel il prend appui.

8. Dispositif selon l'une des revendications précédentes, **caractérisé par** une pluralité de porte-substrats (45), qui sont disposés autour du centre de la plaque de support (3) et qui sont tous entraînés par des flux de gaz.

9. Dispositif selon l'une des revendications précédentes, **caractérisé en ce qu'**une plaque de recouvrement (4) est placée à distance en face du porte-substrat (45) et **en ce que** la plaque de recouvrement (4) est garnie, sur son côté qui est dirigé vers le porte-substrat (45), de plaques (34) qui sont dotées d'un revêtement inerte ou qui sont en un matériau inerte.

10. Dispositif selon la revendication 9, **caractérisé en ce que** les plaques (34) sont conformées en bagues de garniture disposées concentriquement l'une à l'autre.

11. Dispositif selon l'une des revendication 9 ou 10, **caractérisé en ce que** les bagues de garniture (34) sont en TaC ou en graphite recouvert de TaC ou de SiC.

12. Dispositif selon l'une des revendications 9 à 11, **caractérisé en ce que** la bague de garniture (34) la plus intérieure est supportée par un élément d'admission de gaz (6) et les bagues extérieures (34) s'appuient chacune, au niveau de leur bord intérieur (34'), sur le bord extérieur (34') de la bague intérieure adjacente (34).

13. Dispositif selon l'une des revendications 9 à 12, **caractérisé en ce que** la bague intérieure parmi les bagues de garniture (34), disposées concentriquement les unes par rapport aux autres, est constituée de plusieurs parties.
